# EUROPEAN PATENT APPLICATION

(11) **EP 4 672 910 A1**
(43) Date of publication of application: **31.12.2025**
(21) Application number: 25174541.0
(22) Date of filing: 06.05.2025
(51) Int. Cl.: H10D 84/01, H10D 30/00, H10D 84/85

(54) **STRAIN ENGINEERING USING GATE CUTS**

(30) Priority: 27.06.2024 US 202418756437
(71) Applicant: INTEL Corporation, Santa Clara, CA 95054 (US)
(72) Inventor: Hung, Ting-Hsiang, Beaverton, 97007 (US); Zhang, Yang, Rio Rancho, 87124 (US); Chao, Robin, Portland, 97209 (US); Xu, Guowei, Portland, 97229 (US); Tao, Chu, Portland, 97229 (US); Zhang, Feng, Portland, 97229 (US); Lin, Chia-Ching, Portland, 97229 (US); Yeung, Chun Wing, Portland, 97229 (US); Lin, Chung-Hsun, Portland, 97229 (US); Zhang, Kan, Hillsboro, 97123 (US); Murthy, Anand, Portland, 97229 (US)
(74) Representative: Goddar, Heinz J.

(57) **Abstract**

Techniques are provided herein to form semiconductor devices that include one or more gate cuts having materials that impose either a compressive or tensile stress on the adjacent semiconductor devices to improve performance. A semiconductor device includes a gate structure around or otherwise on a semiconductor region. The gate structure may be interrupted, for example, between two transistors with a gate cut that extends through an entire thickness of the gate structure and includes dielectric material to electrically isolate the portions of the gate structure on either side of the gate cut. The gate cut is confined within the gate trench. A first gate cut is arranged between adjacent NMOS devices and includes a dielectric material that imposes a tensile stress on the NMOS devices, and a second gate cut is arranged between adjacent PMOS devices and includes a dielectric material that imposes a compressive stress on the PMOS devices.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, certain factors such as the material stress on the semiconductor channels can have a significant impact on the device performance. Accordingly, there remain a number of non-trivial challenges with respect to forming semiconductor devices.

### BRIEF DESCRIPTION OF THE DRAWINGS

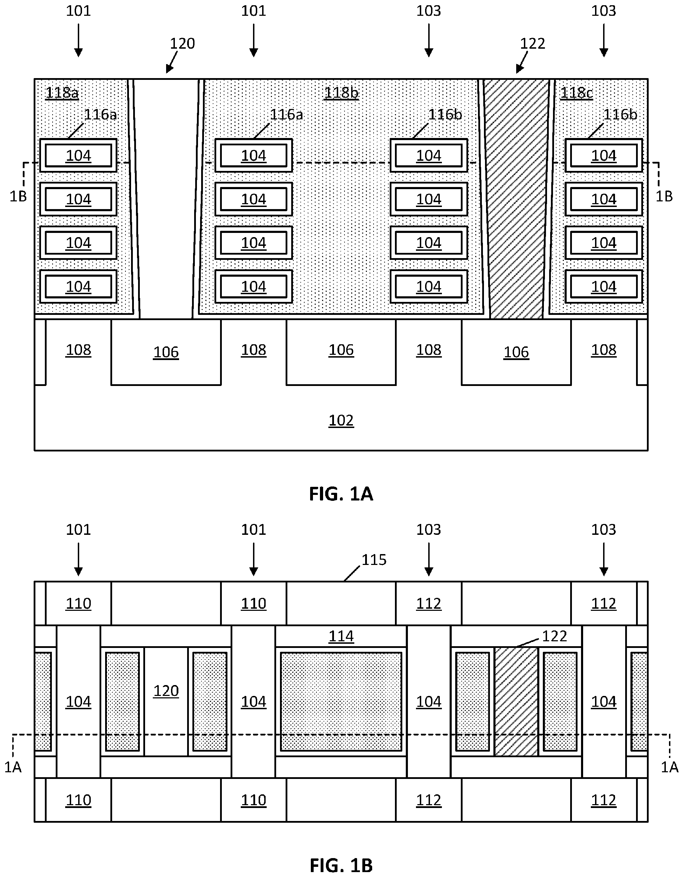

Figures 1A and 1B are cross-sectional and plan views, respectively, of some semiconductor devices that have gate cuts with compositionally different materials to impose compressive or tensile stress, in accordance with an embodiment of the present disclosure.

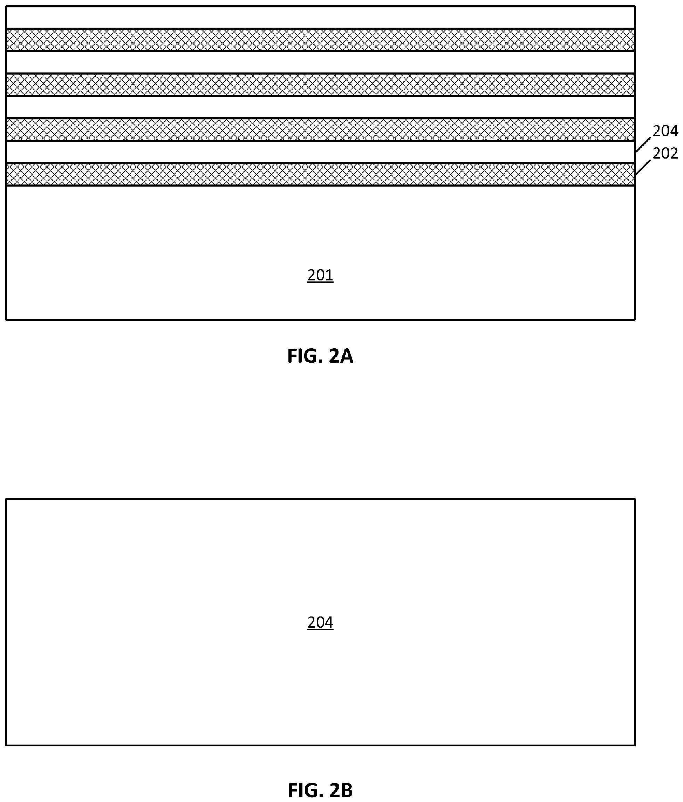

Figures 2A and 2B are cross-sectional and plan views that illustrate a first stage in an example process for forming semiconductor devices that have gate cuts with compositionally different materials to impose compressive or tensile stress, in accordance with some embodiments of the present disclosure.

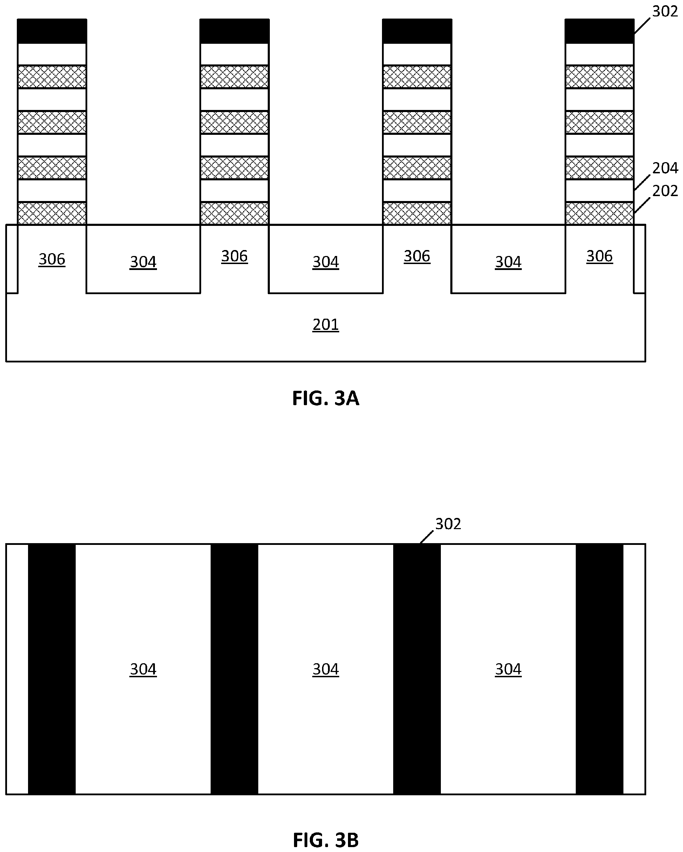

Figures 3A and 3B are cross-sectional and plan views that illustrate another stage in the example process for forming semiconductor devices that have gate cuts with compositionally different materials to impose compressive or tensile stress, in accordance with some embodiments of the present disclosure.

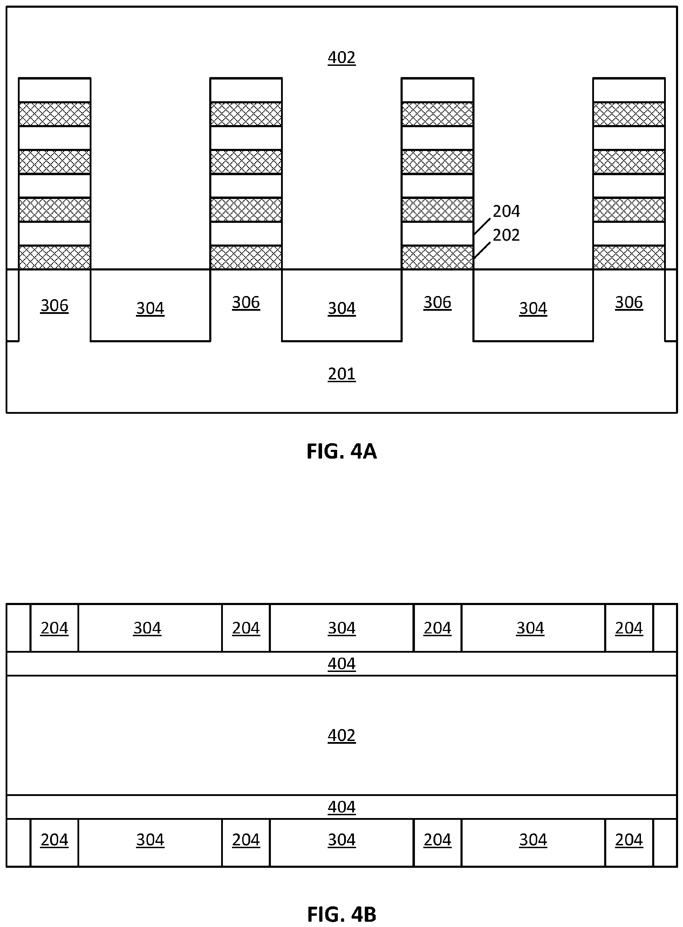

Figures 4A and 4B are cross-sectional and plan views that illustrate another stage in the example process for forming semiconductor devices that have gate cuts with compositionally different materials to impose compressive or tensile stress, in accordance with some embodiments of the present disclosure.

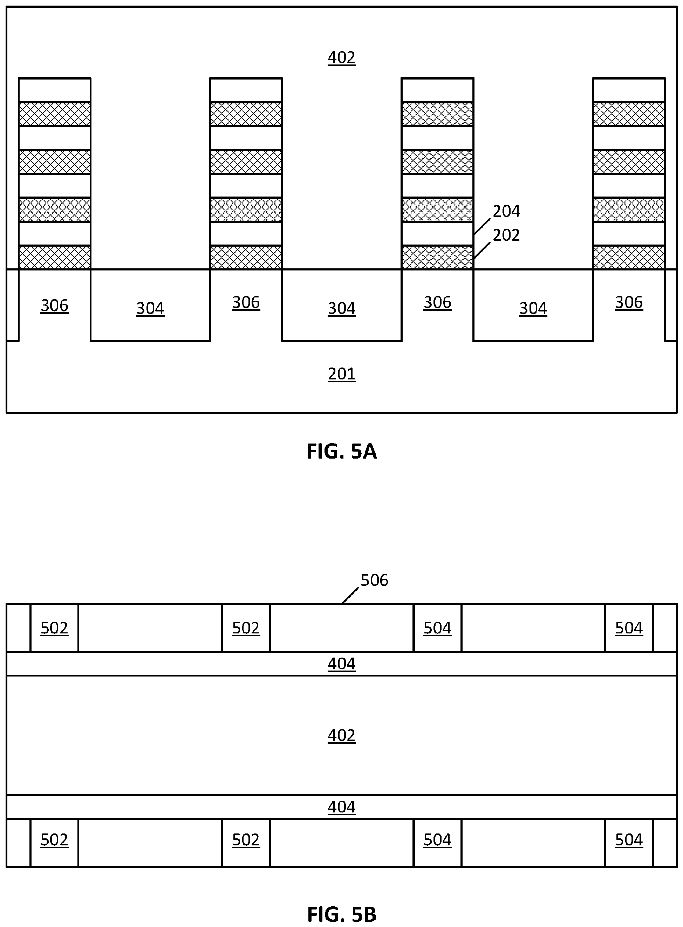

Figures 5A and 5B are cross-sectional and plan views that illustrate another stage in the example process for forming semiconductor devices that have gate cuts with compositionally different materials to impose compressive or tensile stress, in accordance with some embodiments of the present disclosure.

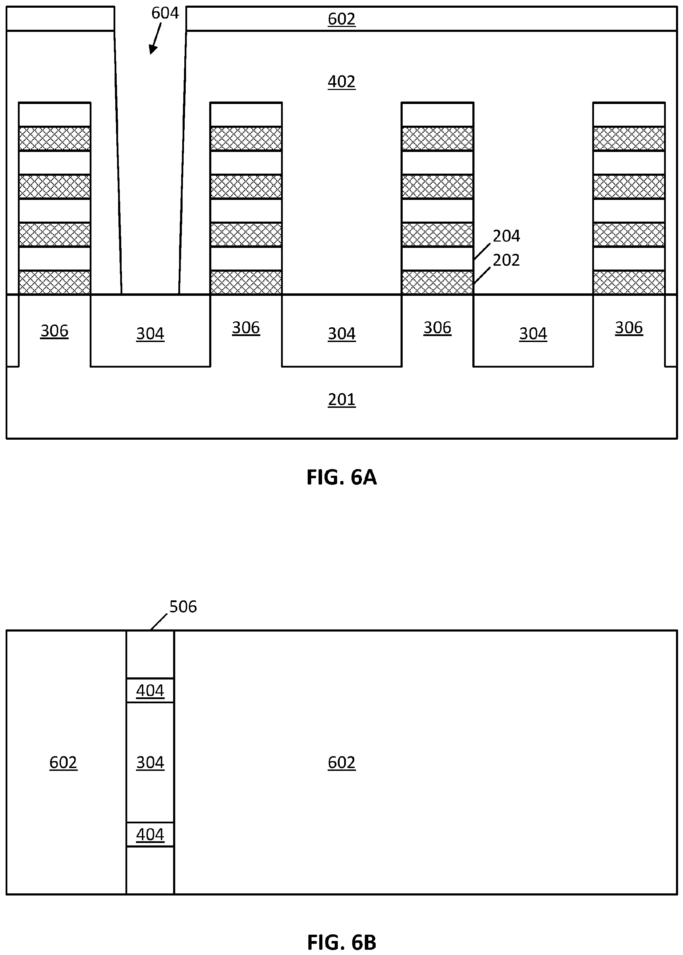

Figures 6A and 6B are cross-sectional and plan views that illustrate another stage in the example process for forming semiconductor devices that have gate cuts with compositionally different materials to impose compressive or tensile stress, in accordance with some embodiments of the present disclosure.

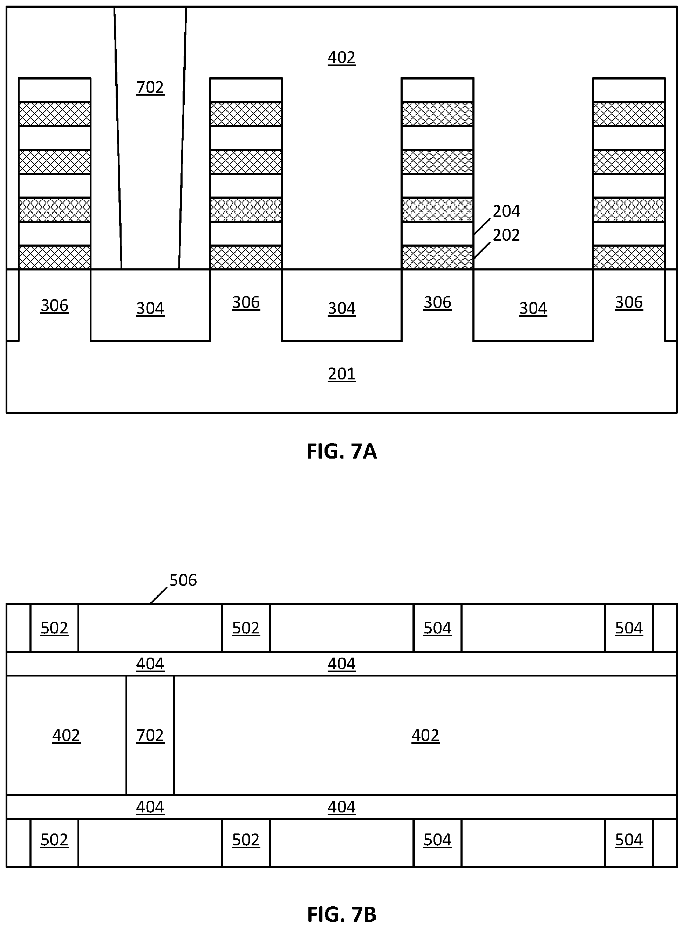

Figures 7A and 7B are cross-sectional and plan views that illustrate another stage in the example process for forming semiconductor devices that have gate cuts with compositionally different materials to impose compressive or tensile stress, in accordance with some embodiments of the present disclosure.

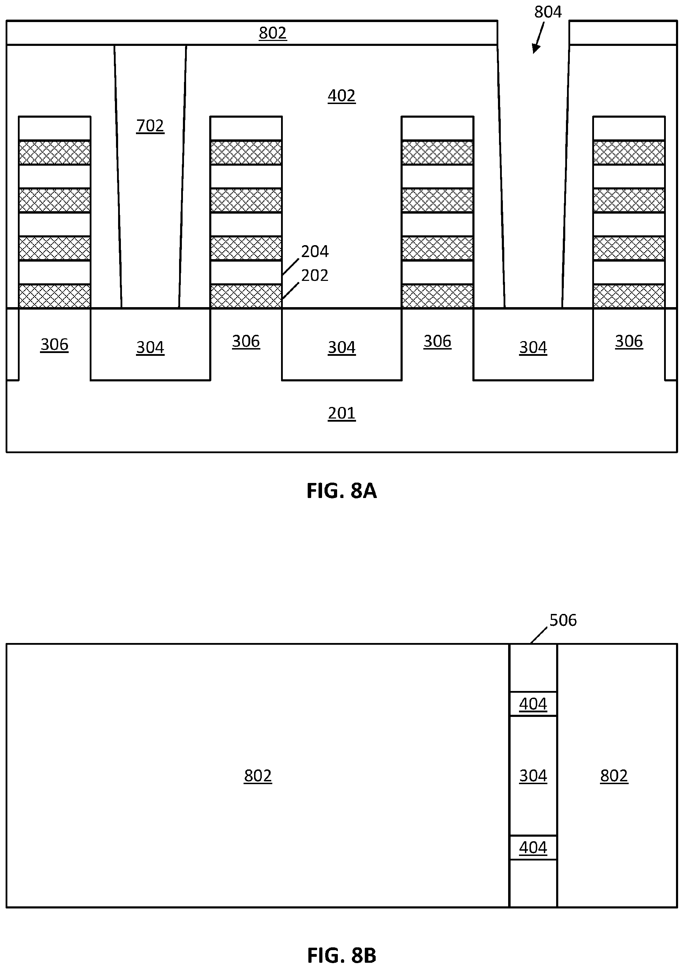

Figures 8A and 8B are cross-sectional and plan views that illustrate another stage in the example process for forming semiconductor devices that have gate cuts with compositionally different materials to impose compressive or tensile stress, in accordance with some embodiments of the present disclosure.

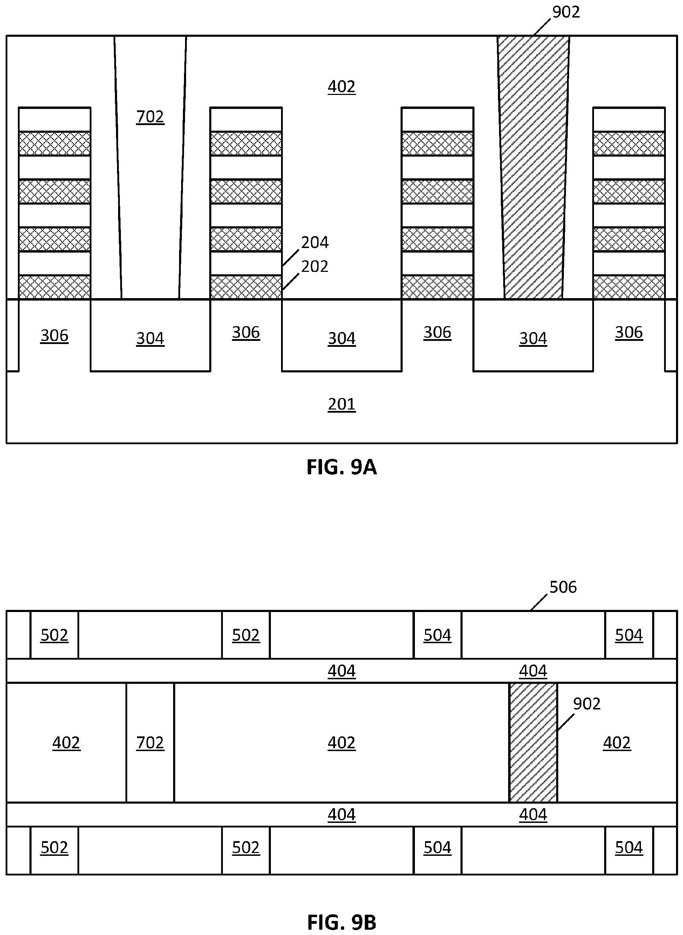

Figures 9A and 9B are cross-sectional and plan views that illustrate another stage in the example process for forming semiconductor devices that have gate cuts with compositionally different materials to impose compressive or tensile stress, in accordance with some embodiments of the present disclosure.

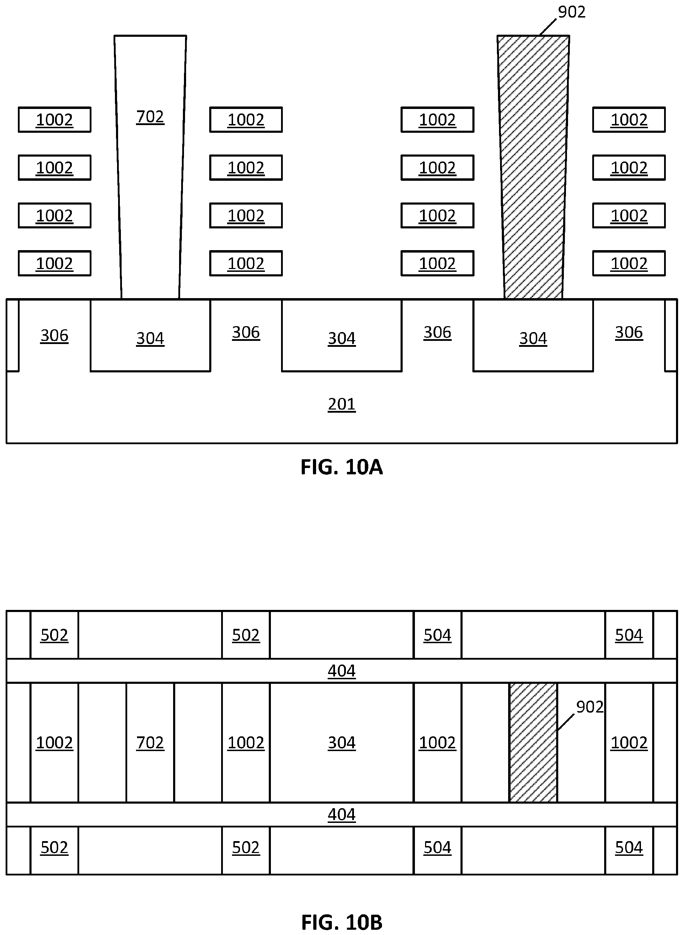

Figures 10A and 10B are cross-sectional and plan views that illustrate another stage in the example process for forming semiconductor devices that have gate cuts with compositionally different materials to impose compressive or tensile stress, in accordance with some embodiments of the present disclosure.

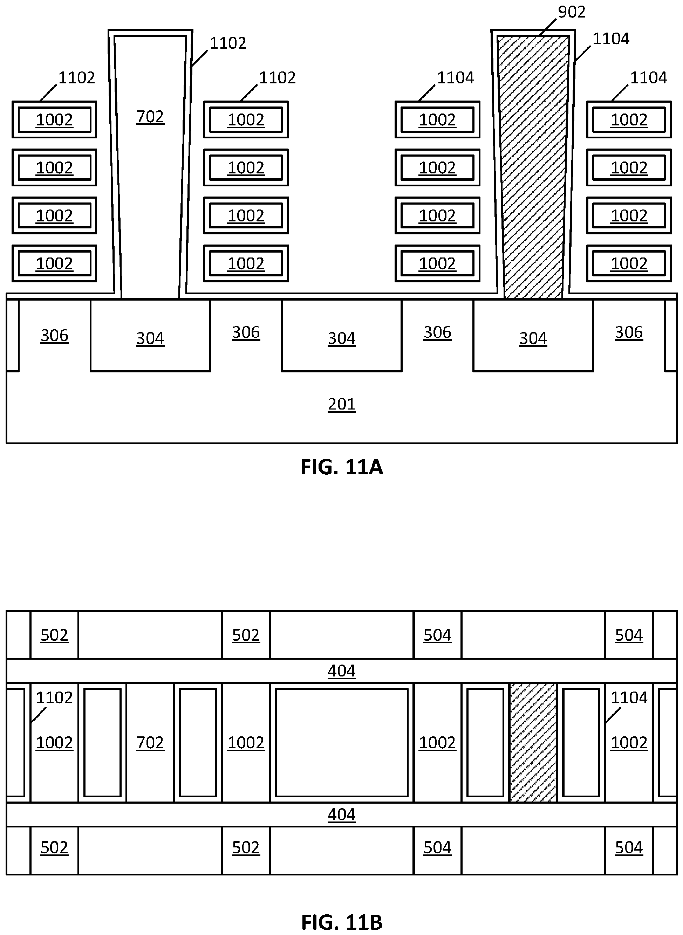

Figures 11A and 11B are cross-sectional and plan views that illustrate another stage in the example process for forming semiconductor devices that have gate cuts with compositionally different materials to impose compressive or tensile stress, in accordance with some embodiments of the present disclosure.

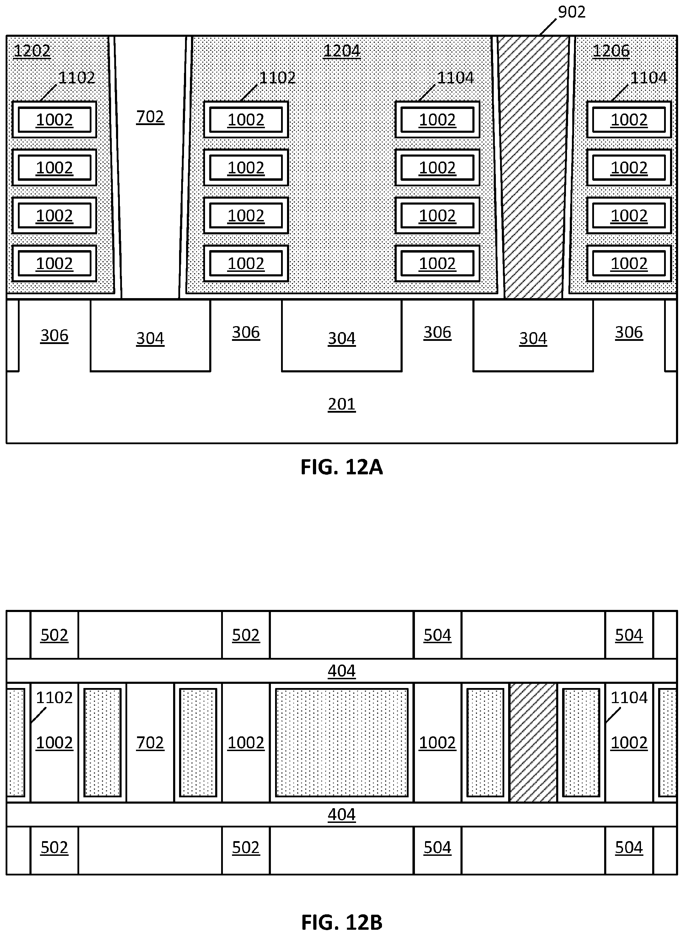

Figures 12A and 12B are cross-sectional and plan views that illustrate another stage in the example process for forming semiconductor devices that have gate cuts with compositionally different materials to impose compressive or tensile stress, in accordance with some embodiments of the present disclosure.

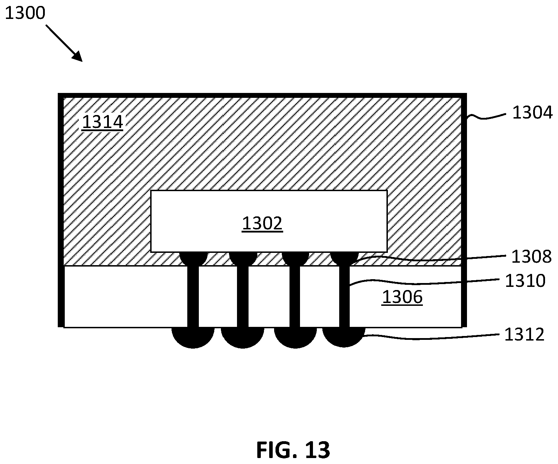

Figure 13 illustrates a cross-sectional view of a chip package containing one or more semiconductor dies, in accordance with some embodiments of the present disclosure.

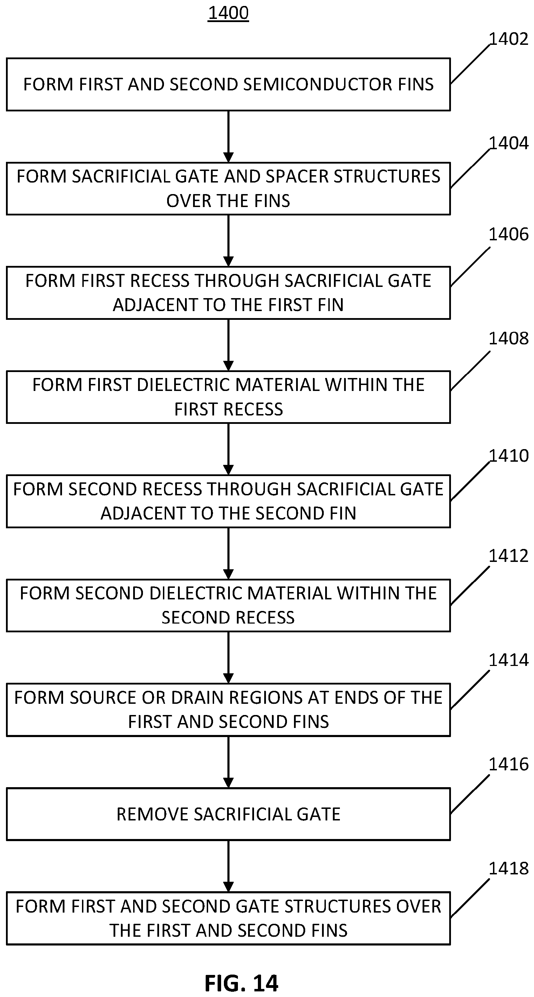

Figure 14 is a flowchart of a fabrication process for semiconductor devices that have gate cuts with compositionally different materials to impose compressive or tensile stress, in accordance with an embodiment of the present disclosure.

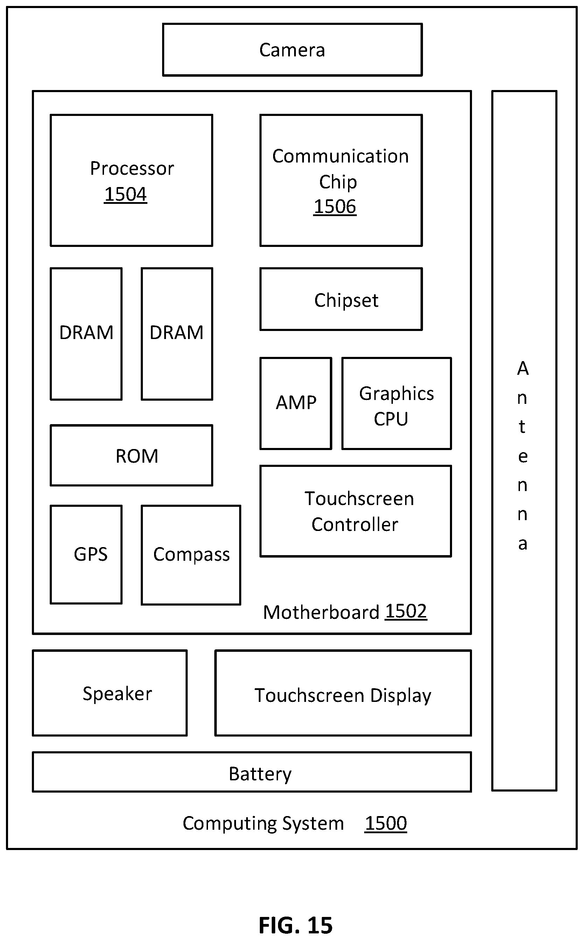

Figure 15 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices that include one or more gate cuts. Different ones of the gate cuts are configured with diverse materials, relative to other ones of the gates. The various materials of the gate cuts can be selected, such that they cause or otherwise impose beneficial stress on the adjacent semiconductor devices to improve performance. The techniques can be used in any number of integrated circuit applications and are particularly useful with respect to device layer transistors, such as finFETs, gate-all-around transistors (e.g., ribbonFETs and nanowire FETs) or forksheet transistors (e.g., nanosheet FETs). In an example, a semiconductor device includes a gate structure around or otherwise on a semiconductor region (also referred to as a channel region). The semiconductor region can be, for example, a fin of semiconductor material that extends from a source region to a drain region, or one or more nanowires or nanoribbons or nanosheets of semiconductor material that extend from a source region to a drain region. The gate structure includes a gate dielectric (e.g., high-k gate dielectric material) and a gate electrode (e.g., conductive material such as workfunction material and/or gate fill metal). The gate structure may be interrupted, for example, between two transistors with a gate cut that extends through an entire thickness of the gate structure and includes dielectric material to electrically isolate the portions of the gate structure on either side of the gate cut. In an example, the gate cut is confined within the gate trench such that it does not extend beyond the walls of the gate trench as defined by gate spacer structures. According to some embodiments, one or more first gate cuts are arranged between n-type transistor devices and include a dielectric material that imposes a tensile stress on the n-type transistor devices, and one or more second gate cuts are arranged between p-type transistor devices and include a dielectric material that imposes a compressive stress on the p-type transistor devices. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. The stress on such small and densely packed structures can have a significant impact on the device performance. For example, tensile stress imposed on a semiconductor channel enhances electron mobility and thus can improve the performance of n-type transistor devices that use electron carriers. Similarly, compressive stress imposed on a semiconductor channel enhances hole mobility and thus can improve the performance of p-type transistor devices that use hole carriers. Tensile or compressive stress is often applied based on growth characteristics of the epitaxial source or drain regions or from changing the semiconductor channel material used between n-type and p-type transistor devices. Such approaches add substantial process complexity, which can lead to lower device yield.

Thus, and in accordance with an embodiment of the present disclosure, techniques are provided herein to impose tensile or compressive stress using gate cuts between adjacent n-type transistor devices or adjacent p-type transistor devices. In some embodiments, gate cuts provided between n-type transistor devices include one or more dielectric materials that impose a tensile stress (such as a nitride, for instance, silicon nitride), and gate cuts provided between p-type transistor devices include one or more dielectric materials that impose a compressive stress (such as an oxide, for instance, silicon dioxide). Any other suitable dielectric materials can be used that impose either tensile or compressive stress. In some embodiments, the ratio of certain elements in the dielectric materials can be tuned to affect the applied stress. For example, gate cuts formed from silicon oxynitride (SiOₓN_{y}) with a higher ratio of nitrogen exhibit a higher tensile stress, while other gate cuts with a higher ratio of oxygen exhibit a higher compressive stress. In some embodiments, the gate cuts may be formed within a gate trench prior to the formation of the gate structure within the gate trench. Accordingly, the gate dielectric of the gate structure may extend over the sidewalls of the gate cuts. Additionally, the gate cuts may be confined within the gate trench, such that the gate cuts do not extend beyond the spacer structures that define the edges of the gate trench.

According to an embodiment, an integrated circuit includes a first semiconductor device having a first semiconductor region extending in a first direction from a first source or drain region, and a first gate structure extending in a second direction over the first semiconductor region, a second semiconductor device having a second semiconductor region extending in the first direction from a second source or drain region, and a second gate structure extending in the second direction over the second semiconductor region, spacer structures on sidewalls of the first and second gate structures and extending along the second direction, a first gate cut adjacent to the first gate structure in the second direction and extending along a third direction through an entire height of the first gate structure, and a second gate cut adjacent to the second gate structure in the second direction and extending along the third direction through an entire height of the second gate structure. The first gate cut includes a first dielectric material contacting the adjacent first gate structure. The second gate cut includes a second dielectric material contacting the adjacent second gate structure. In some such examples, the first dielectric material imposes a compressive stress on the first gate structure, and the second dielectric material imposes a tensile stress on the second gate structure.

According to another embodiment, an integrated circuit includes a first n-channel semiconductor device having a first semiconductor region extending in a first direction from a first source or drain region, and a first gate structure extending in a second direction over the first semiconductor region, a second n-channel semiconductor device having a second semiconductor region extending in the first direction from a second source or drain region, and a second gate structure extending in the second direction over the second semiconductor region, a first p-channel semiconductor device having a third semiconductor region extending in the first direction from a third source or drain region, and a third gate structure extending in the second direction over the third semiconductor region, a second p-channel semiconductor device having a fourth semiconductor region extending in the first direction from a fourth source or drain region, and a fourth gate structure extending in the second direction over the fourth semiconductor region, a first gate cut between the first gate structure and the second gate structure and extending along a third direction through an entire height of the first gate structure and the second gate structure, and a first gate cut between the third gate structure and the fourth gate structure and extending along the third direction through an entire height of the third gate structure and the fourth gate structure. The first gate cut includes a first dielectric material contacting the adjacent first and second gate structures, and the second gate cut includes a second dielectric material contacting the adjacent third and fourth gate structures. The second dielectric material is compositionally different than the first dielectric material.

According to another embodiment, a method of forming an integrated circuit includes forming a first fin comprising first semiconductor material and a second fin comprising second semiconductor material, the first and second fins each extending above a substrate and each extending parallel to one another in a first direction; forming a sacrificial gate extending over the first and second fins in a second direction different from the first direction; forming spacer structures on sidewalls of the sacrificial gate; forming a first recess through an entire thickness of the sacrificial gate adjacent to the first fin; forming a first dielectric material within the first recess; forming a second recess through an entire thickness of the sacrificial gate adjacent to the second fin; forming a second dielectric material within the second recess; forming source or drain regions at ends of the first and second fins; removing the sacrificial gate; forming a first gate structure over the first semiconductor material and against the first dielectric material between the spacer structures; and forming a second gate structure over the second semiconductor material and against the second dielectric material between the spacer structures. The first dielectric material imposes a compressive stress on the first gate structure and the second dielectric material imposes a tensile stress on the second gate structure.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may be used to detect the presence of gate cuts having compositionally different dielectric materials. For example, one or more gate cuts may include only silicon nitride (or other tensile stress inducing nitride) while one or more other gate cuts may include only silicon dioxide (or other compressive stress inducing oxide). Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally or otherwise meaningfully provided at a different concentration in one material relative to the other material (e.g., SiGe having 70 atomic percent germanium is compositionally different than from SiGe having 25 atomic percent germanium). A trivial or otherwise negligible difference in concentration (e.g., a few atomic percent or less, such as might result from one or more real world limitations with respect to a given deposition process) is distinct from an intentional or meaningful difference, in that such a trivial or negligible difference provides little or no intended benefit to circuit performance or manufacturing process. In addition to such chemical composition diversity, the materials may also have distinct dopants (e.g., gallium and magnesium) or the same dopants but at differing concentrations. In still other embodiments, compositionally different or distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

Figure 1A is a cross-sectional view taken across four example semiconductor devices (two p-type transistor devices 101 and two n-type transistor devices 103), according to an embodiment of the present disclosure. Figure 1B is a top-down cross-section view of the semiconductor devices 101 and 103 taken across the dashed line 1B-1B depicted in Figure 1A, and Figure 1A illustrates the cross-section taken across the dashed line 1A-1A depicted in Figure 1B. Each of semiconductor devices 101 and 103 may be, for example, non-planar metal oxide semiconductor (MOS) transistors, such as tri-gate (e.g., finFET) or gate-all-around (GAA) transistors, although other transistor topologies and types could also benefit from the gate cut techniques and structures provided herein. The illustrated example embodiments herein use the GAA structure. Semiconductor devices 101 and 103 represent a portion of an integrated circuit that may contain any number of similar semiconductor devices.

As can be seen, semiconductor devices 101 and 103 are formed on a substrate 102. Any number of semiconductor devices can be formed on substrate 102, but four are used here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some example embodiments, a lower portion of (or all of) substrate 102 is removed and replaced with one or more backside interconnect layers to form backside signal and power routing.

Each of semiconductor devices 101 and 103 includes one or more nanoribbons 104 that extend parallel to one another along a direction between a source region and a drain region (e.g., a first direction into and out of the page in the cross-section view of Figure 1A). Nanoribbons 104 are one example of semiconductor regions or semiconductor bodies that extend between source and drain regions. The term nanoribbon may also encompass other similar shapes such as nanowires or nanosheets. The semiconductor material of nanoribbons 104 may be formed from substrate 102. In some embodiments, semiconductor devices 101 and 103 may each include semiconductor regions in the shape of fins that can be, for example, native to substrate 102 (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of the illustrated nanoribbons 104 during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches, according to some examples.

As can further be seen, adjacent semiconductor devices are separated by a dielectric fill 106 that may include silicon dioxide. Dielectric fill 106 provides shallow trench isolation (STI) between any adjacent semiconductor devices, and more specifically between adjacent subfin regions 108. Dielectric fill 106 can be any suitable dielectric material, such as silicon dioxide, aluminum oxide, or silicon oxycarbonitride.

Semiconductor devices 101 and 103 each include a subfin region 108, in this example. According to some embodiments, subfin region 108 comprises the same semiconductor material as substrate 102 and is adjacent to dielectric fill 106. According to some embodiments, nanoribbons 104 (or other semiconductor bodies) extend between a source and a drain region in the first direction to provide an active region for a transistor (e.g., the semiconductor region beneath the gate). The source and drain regions are not shown in the cross-section of Figure 1A, but are seen in the top-down view of Figure 1B where nanoribbons 104 of semiconductor devices 101 extend between source or drain regions 110 (similarly, the nanoribbons 104 of semiconductor devices 103 extend between source or drain regions 112). Figure 1B also illustrates gate spacer structures 114 that extend around the ends of nanoribbons 104 and along sidewalls of the gate structures between gate spacer structures 114. Spacer structures 114 may include a dielectric material, such as silicon nitride, and may be deposited in a conformal fashion or other suitable deposition process and be etched to a desired thickness (e.g., 2 nm to 10 nm). A dielectric fill 115 may be present between source or drain regions 110/112 along the second direction within a source/drain trench. Dielectric fill 115 may also extend over a top surface of source or drain regions 110/112.

According to some embodiments, the source and drain regions are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. According to some embodiments, semiconductor devices 101 are p-type MOS (PMOS) transistors, and semiconductor devices 103 are n-type MOS (NMOS) transistors. Silicon doped with phosphorous may be used for the n-type source or drain regions 112 while silicon germanium doped with boron may be used for the p-type source or drain regions 110. Any number of source and drain configurations and materials can be used.

According to some embodiments, gate structures extend over nanoribbons 104 of semiconductor devices 101 and 103 along a second direction across the page The second direction may be orthogonal to the first direction. In the illustrated example, three gate structures are separated along the second direction by gate cuts 120 and 122 (as described in more detail below). A first gate structure includes a first gate dielectric 116a and a respective first gate electrode 118a. A second gate structure includes first gate dielectric 116a around nanoribbons 104 of a PMOS device 101, a second gate dielectric 116b around an NMOS device 103, and a respective second gate electrode 118b around both first gate dielectric 116a and second gate dielectric 116b. A third gate structure includes second gate dielectric 116b and a respective third gate electrode 118c. Gate dielectric 116a/116b represents any number of dielectric layers present between nanoribbons 104 and the respective gate electrode 118a/118b/118c. Gate dielectric 116a/116b may also be present on the surfaces of other structures within the gate trench, such as on subfin region 108. Gate dielectric 116a/116b may include any suitable gate dielectric material(s). In some embodiments, gate dielectric 116a/116b includes a layer of native oxide material (e.g., silicon dioxide) on the nanoribbons or other semiconductor regions making up the channel region of the devices, and a layer of high-K dielectric material (e.g., hafnium oxide) on the native oxide.

Gate electrode 118a/118b/118c may represent any number of conductive layers, such as any metal, metal alloy, or doped polysilicon layers. In some embodiments, gate electrode 118a/118b/118c includes one or more workfunction metals around nanoribbons 104. In some embodiments, PMOS semiconductor devices 101 include a workfunction metal having titanium around its nanoribbons 104, and NMOS semiconductor devices 103 include a workfunction metal having tungsten around its nanoribbons 104. Gate electrode 118a/118b/118c may also include a fill metal or other conductive material (e.g., tungsten, ruthenium, molybdenum, cobalt) around the workfunction metals to provide the whole gate electrode structure.

According to some embodiments, adjacent gate structures may be separated along the second direction (e.g., across the page) by a first gate cut 120 or second gate cut 122, which act like a dielectric barrier or wall between gate structures. Each of first gate cut 120 and second gate cut 122 extends vertically (e.g., in a third direction) through at least an entire thickness of the adjacent gate structure. First gate cut 120 and second gate cut 122 may have a top width along the second direction between about 10 nm and about 100 nm, or between about 30 nm and about 50 nm.

According to some embodiments, first gate cut 120 is formed from a different dielectric material compared to second gate cut 122. For example, first gate cut 120 includes a dielectric material that imposes a compressive stress on the adjacent PMOS devices 101, while second gate cut 122 includes a dielectric material that imposes a tensile stress on the adjacent NMOS devices 103. In some embodiments, each of first gate cut 120 and second gate cut 122 only includes a single dielectric material. For example, first gate cut 120 may only include silicon dioxide to impose compressive stress, and second gate cut 122 may only include silicon nitride to impose tensile stress. In some embodiments, first gate cut 120 includes at least 99%, 95%, or 90% silicon dioxide, and second gate cut 122 includes at least 99%, 95%, or 90% silicon nitride. Other examples may include other compositionally different dielectrics that can impose one of tensile or compressive stress (any combination of oxide, nitride, carbide, oxynitride, oxycarbide, carbonitride, or oxycarbonitride dielectric materials).

According to some embodiments, each of first gate cut 120 and second gate cut 122 include a dielectric material having a different elemental ratio to affect the imposed stress. For example, first gate cut 120 may include silicon oxynitride having a higher ratio of oxygen compared to nitrogen to impose a compressive stress, and second gate cut 122 may include silicon oxynitride having a higher ratio of nitrogen compared to oxygen to impose a tensile stress.

According to some embodiments, each of first gate cut 120 and second gate cut 122 extends in the first direction across the entire width of the gate trench as seen in Figure 1B but is confined to the gate trench. Accordingly, gate cuts 120 and 122 do not extend beyond spacer structures 114 along the first direction. As will be discussed in more detail herein, gate cuts 120 and 122 are formed before the formation of the gate structures, such that gate dielectric 116a/116b do extend along the sidewalls of gate cuts 120 and 122. Accordingly, the sidewalls of gate cuts 120 and 122 that extend along the first direction may directly contact gate dielectric 116a/116b and the sidewalls of gate cuts 120 and 122 that extend along the second direction may directly contact spacer structures 114.

### Fabrication Methodology

Figures 2A - 12A and 2B - 12B include cross-sectional and plan views, respectively, that collectively illustrate an example process for forming an integrated circuit with semiconductor devices that have gate cuts with different materials confined within the gate trench between the devices, in accordance with an embodiment of the present disclosure. Figures 2A - 12A represent a similar cross-sectional view as that of Figure 1A across a series of semiconductor devices, while Figures 2B - 12B represent the corresponding plan view at each stage of the fabrication. Each set of figures sharing the same letter shows an example structure that results from the process flow up to that point in time, so the depicted structure evolves as the process flow continues, culminating in the structure shown in Figures 12A - 12B, which is similar to the structure shown in Figures 1A and 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure. Although the fabrication of only two gate cuts is illustrated in the aforementioned figures, it should be understood that any number of similar gate cuts can be fabricated across the integrated circuit using the same processes discussed herein.

Figures 2A and 2B illustrate a cross-sectional view taken through a substrate 201 and a plan view across substrate 201 having a series of material layers formed over the substrate, according to an embodiment of the present disclosure. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201. The description above for substrate 102 applies equally to substrate 201. The plan view of Figure 2B illustrates the topmost semiconductor layer 204 of the layer stack.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

Figures 3A and 3B depict the cross-section and plan views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. The rows of fins extend lengthwise in a first direction (e.g., into and out of the page of Figure 3A).

According to some embodiments, an anisotropic etching process through the layer stack continues into at least a portion of substrate 201. The etched portion of substrate 201 may be filled with a dielectric layer 304 that acts as shallow trench isolation (STI) between adjacent fins. Dielectric layer 304 may be any suitable dielectric material such as silicon dioxide. Subfin regions 306 represent remaining portions of substrate 201 between dielectric layer 304, according to some embodiments. Dielectric layer 304 may be recessed below a top surface of subfin regions 306, according to some embodiments.

Figures 4A and 4B depict the cross-section and plan views of the structure shown in Figures 3A and 3B, respectively, following the formation of a sacrificial gate 402 extending across the fins in a second direction different from the first direction, according to some embodiments. Sacrificial gate 402 may extend across the fins in a second direction that is orthogonal to the first direction. According to some embodiments, the sacrificial gate material is formed in parallel strips across the integrated circuit and removed in all areas not protected by a gate masking layer. Sacrificial gate 402 may be any suitable material that can be selectively removed without damaging the semiconductor material of the fins. In some examples, sacrificial gate 402 includes polysilicon.

Following the formation of sacrificial gate 402, spacer structures 404 may be formed on the sidewalls of sacrificial gate 402. According to some embodiments, a dielectric material is blanket deposited across the structure and etched back to form the spacer structures 404 on the sidewalls of any structures extending above substrate 201. Spacer structures 404 extend along the sides of sacrificial gate 402 along the second direction as illustrated in Figure 4B. In some embodiments, spacer structures may also form on the sides of the fins not under sacrificial gate 402. Spacer structures 404 may be any suitable dielectric material, such as silicon nitride.

Figures 5A and 5B depict the cross-section and plan views of the structure shown in Figures 4A and 4B, respectively, following the removal of any exposed fins and the subsequent formation of p-type source or drain regions 502 at the ends of one or more fins and n-type source or drain regions 504 at the ends of one or more other fins, according to some embodiments. In the illustrated example, p-type source or drain regions 502 are grown from the exposed ends of the left two fins, and n-type source or drain regions 504 are grown from the exposed ends of the right two fins. The exposed fin portions (e.g., not protected by either sacrificial gate 402 or spacer structures 404) may be removed using any anisotropic etching process, such as reactive ion etching (RIE). The removal of the exposed fin portions creates source or drain trenches that alternate with gate trenches (currently filled with sacrificial gates 402) along the first direction, according to some embodiments.

According to some embodiments, source or drain regions 502 and 504 may be formed from the exposed ends of the fins within the source/drain trench. The source or drain regions 502/504 may be formed in the areas that had been previously occupied by the exposed fins adjacent to spacer structures 404. According to some embodiments, source or drain regions 502/504 are epitaxially grown from the exposed semiconductor material at the ends of semiconductor layers 204.

According to some embodiments, a dielectric fill 506 is provided within the source/drain trench. In some examples, dielectric fill 506 occupies a remaining volume within the source/drain trench around and possibly over source or drain regions 502/504. Dielectric fill 506 may be any suitable dielectric material, such as silicon dioxide. In some examples, dielectric fill 506 extends up to and planar with a top surface of spacer structures 404 (e.g., following a polishing procedure).

Figures 6A and 6B depict the cross-section and plan views of the structure shown in Figures 5A and 5B, respectively, following the formation of a mask structure 602 across a top surface of the integrated circuit and the formation of an opening 604 through sacrificial gate 402, according to some embodiments. Mask structure 602 may be any suitable hard mask material that can be safely removed at a later time. In some examples, mask structure 602 includes carbon hard mask (CHM). Mask structure 602 may be patterned to reveal a portion of sacrificial gate 402 between two adjacent semiconductor devices. According to some embodiments, the adjacent semiconductor devices are PMOS devices having p-type source or drain regions 502. The exposed portion of sacrificial gate 402 may be etched using any suitable anisotropic etching process, such as reactive ion etching (RIE). According to some embodiments, opening 604 extends through an entire height of sacrificial gate 402, such that dielectric layer 304 is exposed at the bottom surface of opening 604. As seen in Figure 6B, opening 604 extends in the first direction across the entire width of the gate trench, but does not extend further than spacer structures 404.

Figures 7A and 7B depict the cross-section and plan views of the structure shown in Figures 6A and 6B, respectively, following the formation of a first gate cut 702 within opening 604, according to some embodiments. First gate cut 702 includes a dielectric material that imposes a compressive stress on the adjacent materials. For example, first gate cut 702 includes silicon dioxide or any other oxide-based material that imposes a compressive stress. First gate cut 702 may only consist of silicon dioxide, or include at least 99%, 95%, or 90% silicon dioxide, according to some embodiments. In another example, first gate cut 702 includes a dielectric compound with a higher concentration of oxygen compared to any other element in the compound except for silicon, such as silicon oxynitride with a higher concentration of oxygen compared to nitrogen. Following the deposition of the dielectric material within opening 604, a polishing procedure using, for example, chemical mechanical polishing (CMP) may be performed to planarize the top surface of the device to be substantially level with the top surface of spacer structures 404 and sacrificial gate 402. Accordingly, mask structure 602 may be removed during the polishing procedure.

Figures 8A and 8B depict the cross-section and plan views of the structure shown in Figures 7A and 7B, respectively, following the formation of another mask structure 802 across a top surface of the integrated circuit and the formation of an opening 804 through sacrificial gate 402, according to some embodiments. Mask structure 802 may be any suitable hard mask material that can be safely removed at a later time. In some examples, mask structure 802 includes CHM. Mask structure 802 may be patterned to reveal a portion of sacrificial gate 402 between two adjacent semiconductor devices. According to some embodiments, the adjacent semiconductor devices are NMOS devices having n-type source or drain regions 504. The exposed portion of sacrificial gate 402 may be etched using any suitable anisotropic etching process, such as RIE. According to some embodiments, opening 804 extends through an entire height of sacrificial gate 402, such that dielectric layer 304 is exposed at the bottom surface of opening 804. As seen in Figure 6B, opening 804 extends in the first direction across the entire width of the gate trench, but does not extend further than spacer structures 404.

Figures 9A and 9B depict the cross-section and plan views of the structure shown in Figures 8A and 8B, respectively, following the formation of a second gate cut 902 within opening 804, according to some embodiments. Second gate cut 902 includes a dielectric material that imposes a tensile stress on the adjacent materials. For example, second gate cut 902 includes silicon nitride or any other material that imposes a tensile stress. Second gate cut 902 may only consist of silicon nitride, or include at least 99%, 95%, or 90% silicon nitride, according to some embodiments. In another example, second gate cut 902 includes a dielectric compound with a higher concentration of nitrogen compared to any other element in the compound except for silicon, such as silicon oxynitride with a higher concentration of nitrogen compared to oxygen. Following the deposition of the dielectric material within opening 804, a polishing procedure using, for example, CMP may be performed to planarize the top surface of the device to be substantially level with the top surface of spacer structures 404 and sacrificial gate 402. Accordingly, mask structure 802 may be removed during the polishing procedure. It should be noted that some procedures may be performed in a different order than that presented herein. For example, first gate cut 702 and second gate cut 902 may be formed prior to the formation of first source or drain regions 502 and second source or drain regions 504.

Figures 10A and 10B depict the cross-section and plan views of the structure shown in Figures 9A and 9B, respectively, following the removal of sacrificial gate 402 and the removal of sacrificial layers 202, according to some embodiments. In examples where any gate masking layers are still present, they may also be removed at this time. Once sacrificial gate 402 is removed, the fins that had been beneath sacrificial gate 402 are exposed.

In the example where the fins include alternating semiconductor layers, sacrificial layers 202 are selectively removed to release nanoribbons 1002 that extend between corresponding source or drain regions 502/504. Each vertical set of nanoribbons 1002 represents the semiconductor or channel region of a different semiconductor device. It should be understood that nanoribbons 1002 may also be nanowires or nanosheets (e.g., from a forksheet arrangement) or fins (e.g., for a finFET arrangement). Sacrificial gate 402 and sacrificial layers 202 may be removed using the same isotropic etching process or different isotropic etching processes.

Figures 11A and 11B depict the cross-section and plan views of the structure shown in Figures 10A and 10B, respectively, following the formation of first gate dielectric 1102 and second gate dielectric 1104 within the gate trench, according to some embodiments. Each of first gate dielectric 1102 and second gate dielectric 1104 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 1102/1104 includes a layer of hafnium oxide with a thickness between about 1 nm and about 5 nm. In some embodiments, gate dielectric 1102/1104 may include one or more silicates (e.g., titanium silicate, tungsten silicate, niobium silicate, and silicates of other transition metals). In some cases, gate dielectric 1102/1104 may include a first layer on nanoribbons 1002, and a second layer on the first layer. The first layer can be, for instance, an oxide of the semiconductor material of nanoribbons 1002 (e.g., silicon dioxide) and the second layer can be a high-k dielectric material (e.g., hafnium oxide). More generally, gate dielectric 1102/1104 can include any number of dielectric layers. According to some embodiments, first gate dielectric 1102 formed around the PMOS devices may have a different material composition compared to second gate dielectric 1104 formed around the NMOS devices. According to some embodiments, gate dielectric 1102/1104 forms along all surfaces exposed within the gate trench, such as along inner sidewalls of the spacer structures 404 (as seen in Figure 7B), along the top surfaces of dielectric layer 304 and subfin regions 306, and along sidewalls surfaces of first gate cut 702 and second gate cut 902.

Figures 12A and 12B depict the cross-section and plan views of the structure shown in Figures 11A and 11B, respectively, following the formation of gate electrodes 1202, 1204, and 1206 and subsequent polishing, according to some embodiments. As noted above, each gate electrode 1202, 1204, and 1206 can represent any number of conductive layers. The conductive gate electrodes 1202/1204/1206 may be deposited using electroplating, electroless plating, CVD, PECVD, ALD, or PVD, to name a few examples. In some embodiments, gate electrode 1202/1204/1206 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Each gate electrode 1202/1204/1206 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Accordingly, gate electrode 1204 may include both p-type workfunction materials around the nanoribbons of the PMOS device and n-type workfunction materials around the nanoribbons of the NMOS device. Following the deposition of the conductive materials to form the various gate electrodes along the gate trench, the entire structure may be polished or planarized such that the top surface of the gate structures (e.g., top surface of each gate electrode 1202/1204/1206) is planar with the top surface of other semiconductor elements, such as spacer structures 404 that define the gate trench.

Figure 13 illustrates an example embodiment of a chip package 1300, in accordance with an embodiment of the present disclosure. As can be seen, chip package 1300 includes one or more dies 1302. One or more dies 1302 may include at least one integrated circuit having semiconductor devices, such as any of the semiconductor devices disclosed herein. One or more dies 1302 may include any other circuitry used to interface with other devices formed on the dies, or other devices connected to chip package 1300, in some example configurations.

As can be further seen, chip package 1300 includes a housing 1304 that is bonded to a package substrate 1306. The housing 1304 may be any standard or proprietary housing, and may provide, for example, electromagnetic shielding and environmental protection for the components of chip package 1300. The one or more dies 1302 may be conductively coupled to a package substrate 1306 using connections 1308, which may be implemented with any number of standard or proprietary connection mechanisms, such as solder bumps, ball grid array (BGA), pins, or wire bonds, to name a few examples. Package substrate 1306 may be any standard or proprietary package substrate, but in some cases includes a dielectric material having conductive pathways (e.g., including conductive vias and lines) extending through the dielectric material between the faces of package substrate 1306, or between different locations on each face. In some embodiments, package substrate 1306 may have a thickness less than 1 millimeter (e.g., between 0.1 millimeters and 0.5 millimeters), although any number of package geometries can be used. Additional conductive contacts 1312 may be disposed at an opposite face of package substrate 1306 for conductively contacting, for instance, a printed circuit board (PCB). One or more vias 1310 extend through a thickness of package substrate 1306 to provide conductive pathways between one or more of connections 1308 to one or more of contacts 1312. Vias 1310 are illustrated as single straight columns through package substrate 1306 for ease of illustration, although other configurations can be used (e.g., damascene, dual damascene, through-silicon via, or an interconnect structure that meanders through the thickness of substrate 1306 to contact one or more intermediate locations therein). In still other embodiments, vias 1310 are fabricated by multiple smaller stacked vias, or are staggered at different locations across package substrate 1306. In the illustrated embodiment, contacts 1312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1312, to inhibit shorting.

In some embodiments, a mold material 1314 may be disposed around the one or more dies 1302 included within housing 1304 (e.g., between dies 1302 and package substrate 1306 as an underfill material, as well as between dies 1302 and housing 1304 as an overfill material). Although the dimensions and qualities of the mold material 1314 can vary from one embodiment to the next, in some embodiments, a thickness of mold material 1314 is less than 1 millimeter. Example materials that may be used for mold material 1314 include epoxy mold materials, as suitable. In some cases, the mold material 1314 is thermally conductive, in addition to being electrically insulating.

### Methodology

Figure 14 is a flow chart of a method 1400 for forming at least a portion of an integrated circuit, according to an embodiment. Various operations of method 1400 may be illustrated in Figures 2A - 13A and 2B - 13B. However, the correlation of the various operations of method 1400 to the specific components illustrated in the aforementioned figures is not intended to imply any structural and/or use limitations. Rather, the aforementioned figures provide one example embodiment of method 1400. Other operations may be performed before, during, or after any of the operations of method 1400. For example, method 1400 does not explicitly describe all processes that are performed to form common transistor structures. Some of the operations of method 1400 may be performed in a different order than the illustrated order.

Method 1400 begins with operation 1402 where any number of parallel semiconductor fins are formed, such as first and second fins, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

According to some embodiments, a dielectric layer is formed around subfin portions of each of the first and second fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 1400 continues with operation 1404 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a crosshatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride or silicon oxynitride.

Method 1400 continues with operation 1406 where a first recess is formed through the sacrificial gate adjacent to the first fin. A mask structure may be formed over the structure and patterned to reveal a portion of the sacrificial gate adjacent to the first fin. The exposed portion of the sacrificial gate may be etched using any suitable anisotropic etching process, such as RIE. According to some embodiments, the first recess extends through an entire height of the sacrificial gate and also extends in the first direction across the entire width of the gate trench from the edge of one spacer structure to the edge of the opposite spacer structure on either side of the gate trench.

Method 1400 continues with operation 1408 where a first dielectric material is formed within the first recess. According to some embodiments, the first dielectric material substantially fills the entire volume of the first recess. The first dielectric material may be any suitable material to impose a compressive stress (such as silicon dioxide) or any suitable dielectric material to impose a tensile stress (such as silicon nitride). A top surface of the first dielectric material may be polished using, for example, CMP such that it is substantially coplanar with a top surface of the spacer structures and sacrificial gate.

Method 1400 continues with operation 1410 where a second recess is formed through the sacrificial gate adjacent to the second fin. Another mask structure may be formed over the structure and patterned to reveal a portion of the sacrificial gate adjacent to the second fin. The exposed portion of the sacrificial gate may be etched using any suitable anisotropic etching process, such as RIE. According to some embodiments, the second recess extends through an entire height of the sacrificial gate and also extends in the first direction across the entire width of the gate trench from the edge of one spacer structure to the edge of the opposite spacer structure on either side of the gate trench. In some examples, the second recess has substantially the same dimensions as the first recess.

Method 1400 continues with operation 1412 where a second dielectric material is formed within the second recess. The second dielectric material is compositionally different from the first dielectric material. According to some embodiments, the second dielectric material substantially fills the entire volume of the second recess. The second dielectric material may be any suitable material to impose a compressive stress (such as silicon dioxide) or any suitable dielectric material to impose a tensile stress (such as silicon nitride). If the first dielectric material imposes a compressive stress, then the second dielectric material is chosen to impose a tensile stress and vice versa. A top surface of the second dielectric material may be polished using, for example, CMP such that it is substantially coplanar with a top surface of the spacer structures and sacrificial gate.

Method 1400 continues with operation 1414 where source or drain regions are formed at the ends of the semiconductor regions of each of the fins. Any portions of the fins not protected by the sacrificial gate and spacer structures may be removed using, for example, an anisotropic etching process followed by the epitaxial growth of the source or drain regions from the exposed ends of the semiconductor layers in the fins. In some example embodiments, the source or drain regions are n-type source or drain regions (e.g., epitaxial silicon) or p-type source or drain regions (e.g., epitaxial SiGe). According to some embodiments, the first fin includes n-type source or drain regions (in order to form an NMOS device) if the first dielectric material imposes a tensile stress, and the first fin includes p-type source or drain regions (in order to form a PMOS device) if the first dielectric material imposes a compressive stress. As noted above, the second dielectric material imposes the opposite stress type compared to the first dielectric material, and thus the second fin includes p-type source or drain regions if the first fin includes n-type source or drain regions, and the second fin includes n-type source or drain regions if the first fin includes p-type source or drain regions.

Another dielectric fill may be formed adjacent to the various source or drain regions for additional electrical isolation between adjacent regions. The dielectric fill may also extend over a top surface of the source or drain regions. In some embodiments, topside conductive contacts may be formed through the dielectric fill to contact one or more of the source or drain regions.

Method 1400 continues with operation 1416 where the sacrificial gate is removed. The sacrificial gate may be removed using an isotropic etching process that selectively removes all of the material from the sacrificial gate, thus exposing the various fins between the set of spacer structures. In the example case where GAA transistors are used, any sacrificial layers within the exposed fins between the spacer structures may also be removed to release nanoribbons, nanosheets, or nanowires of semiconductor material. The first and second dielectric materials remain within the gate trench like walls between adjacent fins, according to some embodiments.

Method 1400 continues with operation 1418 where first and second gate structures are formed over the semiconductor material of the first and second fins, respectively. The gate structures may each include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate dielectric may be formed over the sidewalls of the first dielectric material and second dielectric material within the gate trench. The gate electrode can include any number of conductive material layers, such as any metals, metal alloys, or polysilicon. The gate electrode may be deposited using electroplating, electroless plating, CVD, ALD, PECVD, or PVD, to name a few examples. The gate electrode includes one or more workfunction layers that differ between NMOS and PMOS devices.

### Example System

FIG. 15 is an example computing system implemented with one or more of the integrated circuit structures as disclosed herein, in accordance with some embodiments of the present disclosure. As can be seen, the computing system 1500 houses a motherboard 1502. The motherboard 1502 may include a number of components, including, but not limited to, a processor 1504 and at least one communication chip 1506, each of which can be physically and electrically coupled to the motherboard 1502, or otherwise integrated therein. As will be appreciated, the motherboard 1502 may be, for example, any printed circuit board (PCB), whether a main board, a daughterboard mounted on a main board, or the only board of system 1500, etc.

Depending on its applications, computing system 1500 may include one or more other components that may or may not be physically and electrically coupled to the motherboard 1502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1500 may include one or more integrated circuit structures or devices configured in accordance with an example embodiment, such as a module including an integrated circuit on a substrate, the substrate having semiconductor devices that include one or more gate cuts having different dielectric materials to impose either tensile or compressive stress on adjacent devices. In some embodiments, multiple functions can be integrated into one or more chips (e.g., for instance, note that the communication chip 1506 can be part of or otherwise integrated into the processor 1504).

The communication chip 1506 enables wireless communications for the transfer of data to and from the computing system 1500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1500 may include a plurality of communication chips 1506. For instance, a first communication chip 1506 may be dedicated to shorter range wireless communications such as Wi-Fi and Bluetooth and a second communication chip 1506 may be dedicated to longer range wireless communications such as GPS, EDGE, GPRS, CDMA, WiMAX, LTE, Ev-DO, and others.

The processor 1504 of the computing system 1500 includes an integrated circuit die packaged within the processor 1504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1506 also may include an integrated circuit die packaged within the communication chip 1506. In accordance with some such example embodiments, the integrated circuit die of the communication chip includes one or more semiconductor devices as variously described herein. As will be appreciated in light of this disclosure, note that multi-standard wireless capability may be integrated directly into the processor 1504 (e.g., where functionality of any chips 1506 is integrated into processor 1504, rather than having separate communication chips). Further note that processor 1504 may be a chip set having such wireless capability. In short, any number of processor 1504 and/or communication chips 1506 can be used. Likewise, any one chip or chip set can have multiple functions integrated therein.

In various implementations, the computing system 1500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, spacer structures on sidewalls of the first and second gate structures and extending along the second direction, a first gate cut adjacent to the first gate structure in the second direction and extending along a third direction through an entire height of the first gate structure, and a second gate cut adjacent to the second gate structure in the second direction and extending along the third direction through an entire height of the second gate structure. The first gate cut comprises a first dielectric material contacting the adjacent first gate structure. The second gate cut comprises a second dielectric material contacting the adjacent second gate structure. The second dielectric material is compositionally different from the first dielectric material.

Example 2 includes the integrated circuit of Example 1, wherein the first dielectric material imposes a compressive stress on the first gate structure, and the second dielectric material imposes a tensile stress on the second gate structure.

Example 3 includes the integrated circuit of Example 1 or 2, wherein the first dielectric material is elementally different from the second dielectric material.

Example 4 includes the integrated circuit of any one of Examples 1-3, wherein the first dielectric material comprises silicon and oxygen, and the second dielectric material comprises silicon and nitrogen.

Example 5 includes the integrated circuit of any one of Examples 1-4, wherein the first semiconductor device is a p-channel device, and the second semiconductor device is an n-channel device.

Example 6 includes the integrated circuit of any one of Examples 1-5, wherein the first gate cut extends in the first direction between the spacer structures and does not extend beyond the spacer structures, and the second gate cut extends in the first direction between the spacer structures and does not extend beyond the spacer structures.

Example 7 includes the integrated circuit of any one of Examples 1-6, wherein the first gate structure comprises a first gate dielectric and a first gate electrode on the first gate dielectric, and the second gate structure comprises a second gate dielectric and a second gate electrode on the second gate dielectric.

Example 8 includes the integrated circuit of Example 7, wherein the first gate dielectric is on a sidewall of the first gate cut, and the second gate dielectric is on a sidewall of the second gate cut.

Example 9 includes the integrated circuit of Example 8, wherein the first gate electrode does not contact any portion of the sidewall of the first gate cut, and the second gate electrode does not contact any portion of the sidewall of the second gate cut.

Example 10 includes the integrated circuit of Example 8 or 9, wherein the sidewall of the first gate cut is a first sidewall of the first gate cut, and wherein a second sidewall of the first gate cut that extends along the second direction directly contacts one of the spacer structures, and wherein the sidewall of the second gate cut is a first sidewall of the second gate cut, and wherein a second sidewall of the second gate cut that extends along the second direction directly contacts one of the spacer structures.

Example 11 includes the integrated circuit of any one of Examples 1-10, wherein the first and second semiconductor regions each comprise a plurality of semiconductor nanoribbons.

Example 12 includes the integrated circuit of Example 11, wherein the plurality of semiconductor nanoribbons comprise germanium, silicon, or a combination thereof.

Example 13 includes the integrated circuit of any one of Examples 1-12, further comprising a third semiconductor device having a third semiconductor region extending in the first direction from a third source or drain region and a third gate structure extending in the second direction over the third semiconductor region, and a fourth semiconductor device having a fourth semiconductor region extending in the first direction from a fourth source or drain region and a fourth gate structure extending in the second direction over the fourth semiconductor region. The first gate cut separates the first semiconductor device from the third semiconductor device along the second direction, and the second gate cut separates the second semiconductor device from the fourth semiconductor device along the second direction.

Example 14 includes the integrated circuit of Example 13, wherein the first and third semiconductor devices are p-channel devices and the second and fourth semiconductor devices are n-channel devices.

Example 15 includes the integrated circuit of any one of Examples 1-14, wherein the first dielectric material comprises silicon, oxygen, and nitrogen with a higher concentration of oxygen compared to nitrogen, and the second dielectric material comprises silicon, oxygen, and nitrogen with a higher concentration of nitrogen compared to oxygen.

Example 16 is a printed circuit board comprising the integrated circuit of any one of Examples 1-15.

Example 17 is an electronic device that includes a chip package having one or more dies. At least one of the one or more dies includes a first semiconductor region extending in a first direction from a first source or drain region, a first gate structure extending in a second direction over the first semiconductor region, a second semiconductor region extending in the first direction from a second source or drain region, a second gate structure extending in the second direction over the second semiconductor region, spacer structures on sidewalls of the first and second gate structures and extending along the second direction, a first gate cut adjacent to the first gate structure and extending along a third direction through an entire height of the first gate structure, and a second gate cut adjacent to the second gate structure and extending along a third direction through an entire height of the second gate structure. The first gate cut comprises a first dielectric material contacting the adjacent first gate structure, and the second gate cut comprises a second dielectric material contacting the adjacent second gate structure. The first dielectric material imposes a compressive stress on the first gate structure, and the second dielectric material imposes a tensile stress on the second gate structure.

Example 18 includes the electronic device of Example 17, wherein the first dielectric material comprises silicon and oxygen, and the second dielectric material comprises silicon and nitrogen.

Example 19 includes the electronic device of Example 17 or 18, wherein the first semiconductor region is part of a p-channel device, and the second semiconductor region is part of an n-channel device.

Example 20 includes the electronic device of any one of Examples 17-19, wherein the first gate cut extends in the first direction between the spacer structures and does not extend beyond the spacer structures, and the second gate cut extends in the first direction between the spacer structures and does not extend beyond the spacer structures.

Example 21 includes the electronic device of any one of Examples 17-20, wherein the first gate structure comprises a first gate dielectric and a first gate electrode on the first gate dielectric, and the second gate structure comprises a second gate dielectric and a second gate electrode on the second gate dielectric.

Example 22 includes the electronic device of Example 21, wherein the first gate dielectric is on a sidewall of the first gate cut, and the second gate dielectric is on a sidewall of the second gate cut.

Example 23 includes the electronic device of Example 22, wherein the first gate electrode does not contact any portion of the sidewall of the first gate cut, and the second gate electrode does not contact any portion of the sidewall of the second gate cut.

Example 24 includes the electronic device of Example 22 or 23, wherein the sidewall of the first gate cut is a first sidewall of the first gate cut, and wherein a second sidewall of the first gate cut that extends along the second direction directly contacts one of the spacer structures, and wherein the sidewall of the second gate cut is a first sidewall of the second gate cut, and wherein a second sidewall of the second gate cut that extends along the second direction directly contacts one of the spacer structures.

Example 25 includes the electronic device of any one of Examples 17-24, wherein the first and second semiconductor regions each comprise a plurality of semiconductor nanoribbons.

Example 26 includes the electronic device of Example 25, wherein the plurality of semiconductor nanoribbons comprise germanium, silicon, or a combination thereof.

Example 27 wherein the at least one of the one or more dies further comprises a third semiconductor region extending in the first direction from a third source or drain region, a third gate structure extending in the second direction over the third semiconductor region, a fourth semiconductor region extending in the first direction from a fourth source or drain region, and a fourth gate structure extending in the second direction over the fourth semiconductor region. The first gate cut separates the first gate structure from the third gate structure along the second direction, and the second gate cut separates the second gate structure from the fourth gate structure along the second direction.

Example 28 includes the electronic device of Example 27, wherein the first and third semiconductor regions are part of p-channel devices and the second and fourth semiconductor regions are part of n-channel devices.

Example 29 includes the electronic device of any one of Examples 17-28, wherein the first dielectric material comprises silicon, oxygen, and nitrogen with a higher concentration of oxygen compared to nitrogen, and the second dielectric material comprises silicon, oxygen, and nitrogen with a higher concentration of nitrogen compared to oxygen.

Example 30 includes the electronic device of any one of Examples 17-29, further comprising a printed circuit board, wherein the chip package is coupled to the printed circuit board.

Example 31 is a method of forming an integrated circuit. The method includes forming a first fin comprising first semiconductor material and a second fin comprising second semiconductor material, the first and second fins each extending above a substrate and each extending parallel to one another in a first direction; forming a sacrificial gate extending over the first and second fins in a second direction different from the first direction; forming spacer structures on sidewalls of the sacrificial gate; forming a first recess through an entire thickness of the sacrificial gate adjacent to the first fin; forming a first dielectric material within the first recess; forming a second recess through an entire thickness of the sacrificial gate adjacent to the second fin; forming a second dielectric material within the second recess; forming source or drain regions at ends of the first and second fins; removing the sacrificial gate; forming a first gate structure over the first semiconductor material and against the first dielectric material between the spacer structures; and forming a second gate structure over the second semiconductor material and against the second dielectric material between the spacer structures. The first dielectric material imposes a compressive stress on the first gate structure and the second dielectric material imposes a tensile stress on the second gate structure.

Example 32 includes the method of Example 31, wherein the first dielectric material comprises silicon and oxygen, and the second dielectric material comprises silicon and nitrogen.

Example 33 includes the method of Example 31 or 32, wherein the first recess extends an entire distance between the spacer structures along the first direction, and wherein the second recess extends an entire distance between the spacer structures along the first direction.

Example 34 includes the method of any one of Examples 31-33, wherein forming the first dielectric material comprises forming a first liner within the first recess and forming a first fill on the first liner, each of the first fill and the first liner comprising the first dielectric material, and wherein forming the second dielectric material comprises forming a second liner within the second recess and forming a second fill on the second liner, each of the second fill and the second liner comprising the second dielectric material.

Example 35 is an integrated circuit that includes a first n-channel semiconductor device having a first semiconductor region extending in a first direction from a first source or drain region and a first gate structure extending in a second direction over the first semiconductor region, a second n-channel semiconductor device having a second semiconductor region extending in the first direction from a second source or drain region and a second gate structure extending in the second direction over the second semiconductor region, a first p-channel semiconductor device having a third semiconductor region extending in the first direction from a third source or drain region and a third gate structure extending in the second direction over the third semiconductor region, a second p-channel semiconductor device having a fourth semiconductor region extending in the first direction from a fourth source or drain region and a fourth gate structure extending in the second direction over the fourth semiconductor region, a first gate cut between the first gate structure and the second gate structure and extending along a third direction through an entire height of the first gate structure and the second gate structure, and a second gate cut between the third gate structure and the fourth gate structure and extending along the third direction through an entire height of the third gate structure and the fourth gate structure. The first gate cut comprises a first dielectric material contacting the adjacent first and second gate structures, and the second gate cut comprises a second dielectric material contacting the adjacent third and fourth gate structures. The second dielectric material is elementally different than the first dielectric material.

Example 36 includes the integrated circuit of Example 35, wherein the first dielectric material comprises silicon and nitrogen, and the second dielectric material comprises silicon and oxygen.

Example 37 includes the integrated circuit of Example 35 or 36, wherein the first dielectric material imposes a tensile stress on the first and second gate structures, and the second dielectric material imposes a compressive stress on the third and fourth gate structures.

Example 38 includes the integrated circuit of any one of Examples 35-37, further comprising spacer structures on sidewalls of each of the first, second, third, and fourth gate structures and extending along the second direction.

Example 39 includes the integrated circuit of Example 38, wherein the first gate cut extends in the first direction between the spacer structures and does not extend beyond the spacer structures, and the second gate cut extends in the first direction between the spacer structures and does not extend beyond the spacer structures.

Example 40 includes the integrated circuit of any one of Examples 35-39, wherein the first gate structure comprises a first gate dielectric and a first gate electrode on the first gate dielectric, and the second gate structure comprises a second gate dielectric and a second gate electrode on the second gate dielectric.

Example 41 includes the integrated circuit of Example 40, wherein the first gate dielectric is on a first sidewall of the first gate cut, and the second gate dielectric is on an opposite second sidewall of the first gate cut.

Example 42 includes the integrated circuit of any one of Examples 35-41, wherein the third gate structure comprises a first gate dielectric and a first gate electrode on the first gate dielectric, and the fourth gate structure comprises a second gate dielectric and a second gate electrode on the second gate dielectric.

Example 43 includes the integrated circuit of Example 42, wherein the first gate dielectric is on a first sidewall of the second gate cut and the second gate dielectric is on an opposite second sidewall of the second gate cut.

Example 44 includes the integrated circuit of any one of Examples 35-43, wherein each of the first, second, third, and fourth semiconductor regions comprise a plurality of semiconductor nanoribbons.

Example 45 includes the integrated circuit of Example 44, wherein the plurality of semiconductor nanoribbons comprise germanium, silicon, or a combination thereof.

Example 46 includes the integrated circuit of any one of Examples 35-45, wherein the second gate structure and the third gate structure are a same gate structure extending along the second direction.

Example 47 is a printed circuit board comprising the integrated circuit of any one of Examples 35-46.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor region extending in a first direction from a first source or drain region, and a first gate structure extending in a second direction over the first semiconductor region;
a second semiconductor device having a second semiconductor region extending in the first direction from a second source or drain region, and a second gate structure extending in the second direction over the second semiconductor region;
spacer structures on sidewalls of the first and second gate structures and extending along the second direction;
a first gate cut adjacent to the first gate structure in the second direction and extending along a third direction through an entire height of the first gate structure, wherein the first gate cut comprises a first dielectric material contacting the adjacent first gate structure; and
a second gate cut adjacent to the second gate structure in the second direction and extending along the third direction through an entire height of the second gate structure, wherein the second gate cut comprises a second dielectric material contacting the adjacent second gate structure, the second dielectric material compositionally different from the first dielectric material.

2. The integrated circuit of claim 1, wherein the first dielectric material imposes a compressive stress on the first gate structure, and the second dielectric material imposes a tensile stress on the second gate structure.

3. The integrated circuit of claim 1 or 2, wherein the first dielectric material is elementally different from the second dielectric material.

4. The integrated circuit of any one of claims 1 through 4, wherein the first dielectric material comprises silicon and oxygen, and the second dielectric material comprises silicon and nitrogen.

5. The integrated circuit of any one of claims 1 through 4, wherein the first semiconductor device is a p-channel device, and the second semiconductor device is an n-channel device.

6. The integrated circuit of any one of claims 1 through 5, wherein the first gate cut extends in the first direction between the spacer structures and does not extend beyond the spacer structures, and the second gate cut extends in the first direction between the spacer structures and does not extend beyond the spacer structures.

7. The integrated circuit of any one of claims 1 through 6, wherein the first gate structure comprises a first gate dielectric and a first gate electrode on the first gate dielectric, and the second gate structure comprises a second gate dielectric and a second gate electrode on the second gate dielectric.

8. The integrated circuit of claim 7, wherein the first gate dielectric is on a sidewall of the first gate cut, and the second gate dielectric is on a sidewall of the second gate cut.

9. The integrated circuit of claim 8, wherein the first gate electrode does not contact any portion of the sidewall of the first gate cut, and the second gate electrode does not contact any portion of the sidewall of the second gate cut.

10. The integrated circuit of claim 8 or 9, wherein the sidewall of the first gate cut is a first sidewall of the first gate cut, and wherein a second sidewall of the first gate cut that extends along the second direction directly contacts one of the spacer structures, and wherein the sidewall of the second gate cut is a first sidewall of the second gate cut, and wherein a second sidewall of the second gate cut that extends along the second direction directly contacts one of the spacer structures.

11. The integrated circuit of any one of claims 1 through 10, wherein the first and second semiconductor regions each comprise a plurality of semiconductor nanoribbons.

12. The integrated circuit of any one of claims 1 through 11, further comprising a third semiconductor device having a third semiconductor region extending in the first direction from a third source or drain region and a third gate structure extending in the second direction over the third semiconductor region, and a fourth semiconductor device having a fourth semiconductor region extending in the first direction from a fourth source or drain region and a fourth gate structure extending in the second direction over the fourth semiconductor region, wherein the first gate cut separates the first semiconductor device from the third semiconductor device along the second direction, and the second gate cut separates the second semiconductor device from the fourth semiconductor device along the second direction.

13. The integrated circuit of claim 12, wherein the first and third semiconductor devices are p-channel devices and the second and fourth semiconductor devices are n-channel devices.

14. The integrated circuit of any one of claims 1 through 13, wherein the first dielectric material comprises silicon, oxygen, and nitrogen with a higher concentration of oxygen compared to nitrogen, and the second dielectric material comprises silicon, oxygen, and nitrogen with a higher concentration of nitrogen compared to oxygen.

15. A printed circuit board comprising the integrated circuit of any one of claims 1 through 14.
